# EUROPEAN PATENT APPLICATION

(11) **EP 2 296 284 A1**
(43) Date of publication of application: **16.03.2011**
(21) Application number: 10185993.2
(22) Date of filing: 15.04.1998
(51) Int. Cl.: H03M 13/29, H03M 13/00

(54) **Turbo-coding with staged data transmission and processing**

(30) Priority: 21.04.1997 US 845095
(62) Divisional of application: 08002038.1
(71) Applicant: General Electric Company, Schenectady, NY 12345 (US)
(72) Inventor: Ross, John Anderson Fergus, Schenectady, NY 12309 (US)
(74) Representative: Kopf, Korbinian Paul

(57) **Abstract**

Turbo-coding in a communications system involves coding/decoding information in stages in order to avoid retransmission of a full L-bit packet upon occurrence of a packet error. In addition to a set of code bits generated by an encoder using a turbo-coding scheme, a punctured set of code bits is generated and stored in transmitter memory. The original set of code bits is transmitted as an L-bit data packet to a receiver which stores received data samples corresponding to the original set of code bits. The receiver decodes the data packet using a turbo-decoder and determines whether the data packet has been received in error. If so, the received data samples are maintained in memory, and a request for more information is made. Some or all of the punctured information is then forwarded from the transmitter to the receiver. A second stage of turbo-decoding combines the new data samples with the stored original received data samples such that there is a high likelihood that decoding is correct at this point, but additional stages of decoding may be used.

## Description

The present invention relates generally to coding in communications systems and, more particularly, to turbo-coding information in stages.

Turbo-coding is known in the art as another term for parallel concatenated convolutional coding. More specifically, turbocoding involves encoding an information sequence twice, the second encoding being performed after a random interleaving of the information sequence. Decoding is performed iteratively, and the result is reliable communication.

In many communications systems, data is transmitted in L-bit packets, where L is typically on the order of between ten and several hundred. If the receiver determines that the packet has been received in error, there may be a request to retransmit the information, referred to as an automatic repeat request (ARQ). Disadvantageously, this results in the transmission of a total of 2L -bits.

Accordingly, it is desirable to provide a method and apparatus for turbo-coding which does not require a full L-bit packet to be retransmitted upon occurrence of a packet error.

A method and apparatus for turbo-coding stages of information in a communications system avoids retransmission of a full L-bit packet upon occurrence of a packet error. In accordance therewith, in addition to a set of code bits generated by an encoder using a turbo-coding scheme, a punctured set of code bits is generated and stored in transmitter memory. The original set of code bits is transmitted as an L-bit data packet, via a channel, to a receiver which stores the received data samples corresponding to the original set of code bits. The receiver decodes the data packet using a turbo-decoder and determines whether the data packet has been received in error. If so, the received data samples are maintained in memory, and a request for more information is made. Some or all of the punctured information is then forwarded from the transmitter, via the channel, to the receiver. A second stage of turbo-decoding combines the new (i.e., punctured) data samples with the stored original received data samples. Decoding is likely to be correct at this point. However, it may be desirable to have three or more transmission stages of decoding, depending upon the application.

Embodiments of the invention will now be described, by way of example, with reference to the accompanying drawings, in which:
FiG. 1 is a block diagram illustrating a turbo-coding scheme with staged information transmission according to an embodiment of the present invention;
FIG. 2 is a block diagram illustrating turbo-coding with staged information transmission using rate 1/3 with systematic encoders according to an embodiment of the present invention;
FIG. 3 is a block diagram illustrating a staged decoder according to an embodiment of the present invention;
FIG. 4 is a flow chart illustrating staged information turbo-coding, i.e., at the transmitter, according to an embodiment of the present invention; and
FIG. 5 is a flow chart illustrating stage information turbo-decoding according to an embodiment of the present invention.

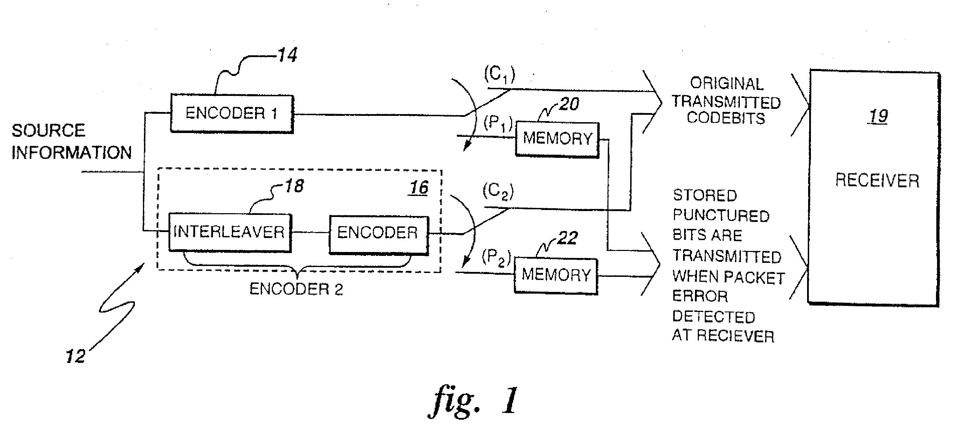

FIG. 1 illustrates a turbo-coding scheme with staged information transmission according to an embodiment of the present invention. In FIG. 1, a turbo encoder 12 encodes source information using a parallel concatenation of two convolutional codes in encoder 14 and in encoder 16, typically referred to in the art as Encoder 1 and Encoder 2, respectively. The second encoder, encoder 16, performs the second encoding after random interleaving in an interleaver 18.

The code bits C1 and C2 are transmitted via a channel to a receiver 19. A set of data samples corresponding to the original transmitted code bits C1 and C2 from encoder 16 and encoder 18, respectively, are received by receiver 19 and stored in receiver memory. A punctured set of code bits P1 and P2, respectively, corresponding to code bits C1 and C2, respectively, is also generated by encoder 12 and stored in transmitter memory 20 and memory 22, respectively.

As known in the art, an encoder applies a puncturing process to a convolutional code by deleting some output bits according to a predetermined puncturing pattern in order to increase the rate of the resulting code. The associated decoder in receiver 19 includes a corresponding depuncturing function which involves inserting a neutral value for each known punctured bit. The size of the punctured set of code bits is determined by the bandwidth, power, and retransmission frequency of the system.

Receiver 19 decodes the data by turbo-decoding and determines whether the packet has been received in error. If so, then the received data samples corresponding to code bits C1 and C2 are maintained in memory. The receiver makes a request for more information, whereby some or all of the stored punctured bits are transmitted, via the channel, to the receiver. A second stage of turbodecoding is performed, combining the data samples corresponding to punctured code bits P1 and P2 with the original received data samples corresponding to code bits C1 and C2. Advantageously, it is highly likely that decoding is correct at this point, resulting in highly reliable communication. However, depending upon the application, three or more transmission stages of turbo-decoding may be desirable.

Turbo-coding commonly involves the use of systematic convolutional codes for which input bits appear directly in the code output. To increase the rate of such a code, another form of puncturing may be applied wherein only one copy of the systematic bits is transmitted, which copy is used by all convolutional decoders in the turbo-decoding process. The staged transmission process described hereinabove may be applied to this form of puncturing as well. In particular, if a packet is received in error, a retransmission of the systematic bits is requested with the newly received samples applied to one or more convolutional decoders of the turbo-decoding algorithm.

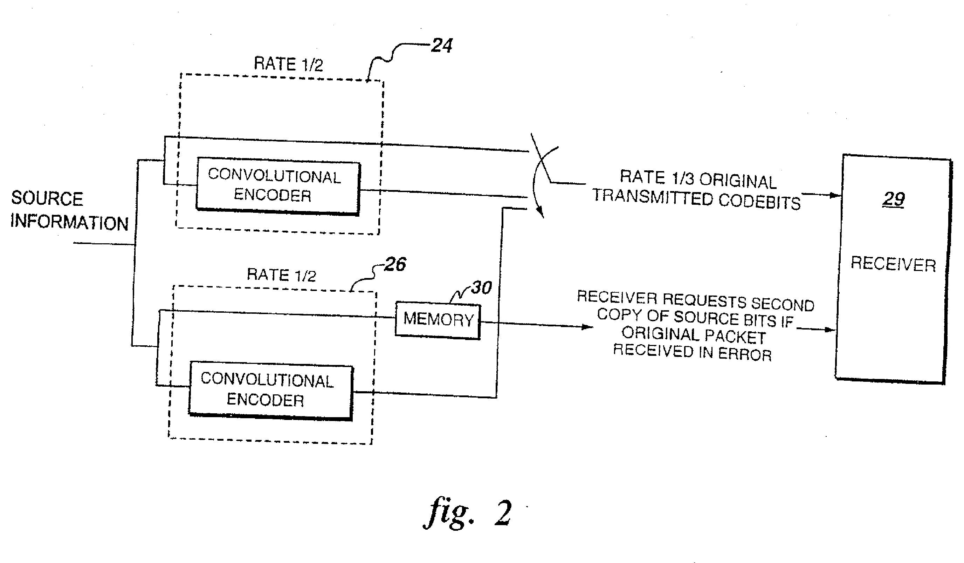

FIG. 2 illustrates an example of turbo-decoding of a systematic code with staged information transmission. In this example, a rate 1/3 turbo code is created by transmitting the full code output of a rate 1/2 systematic convolutional encoder 24 operating on the original input sequence while transmitting only the parity bits of a second systematic convolutional encoder 26, also rate 1/2, operating on an interleaved copy of the input sequence. At a receiver 29, the received data samples corresponding to the systematic bits are used for both of the convolutional decoding components of the turbo code. The receiver requests a second copy of the systematic bits via memory 30 only if the first attempt at decoding results in a detected packet error. The received data samples corresponding to the second copy of the systematic bits is used for the second convolutional decoder component. Advantageously, the newly requested information is only 1/3 of the number of transmitted bits required in the classical automatic repeat request (ARQ) scheme.

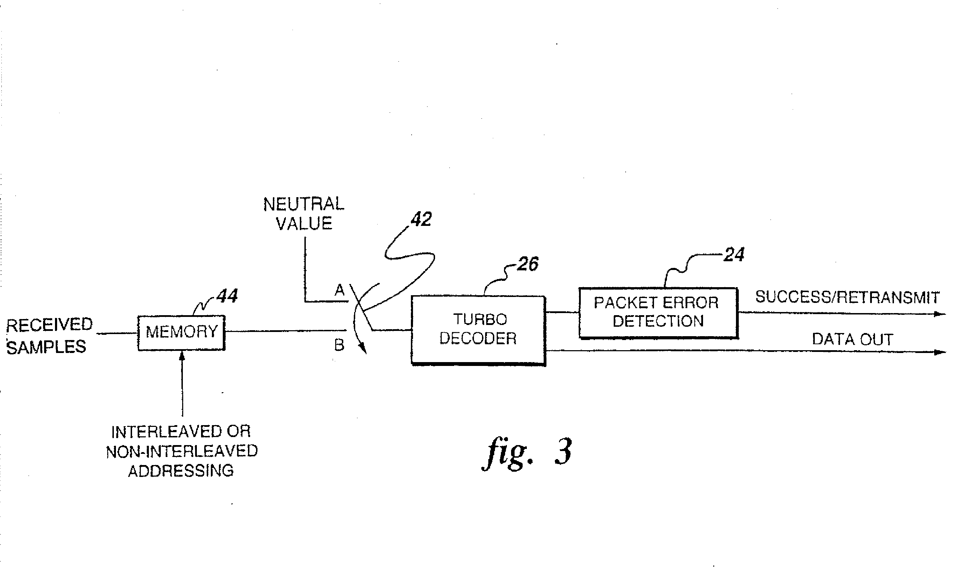

FIG. 3 illustrates a staged turbo decoder 40 in a receiver according to an embodiment of the present invention. The input to decoder 40 is controlled by an input data selector 42. The received data samples corresponding to the transmitted code bits are copied into memory 44 in the first stage of transmission and are used in each iteration in the turbo decoding process. Memory 44 also allows systematic information that is common to encoder 1 and encoder 2 FIGs. 1 and 2) to be transmitted only once in the first stage of turbo decoding. In the first stage of decoding, the data selector chooses A when the information has been punctured and chooses B when the received data samples are available. Memory 44 is addressed by the non-interleaving sequence when encoder 1 data is processed and by the interleaving sequence when encoder 2 data is processed.

After the first stage of turbo-decoding, a packet error detection mechanism 50 determines whether the data was received correctly. An exemplary packet error detection mechanism comprises a well-known 16-bit cyclic redundancy check (CRC) code. As described hereinabove, if a packet error is detected, a request for transmission of information previously punctured and/or for a second set of systematic data is made. The new information is also stored in memory 44. The second stage of decoding then takes place with the more complete information; i.e., the previously punctured information is combined with the new stage of information and decoded.

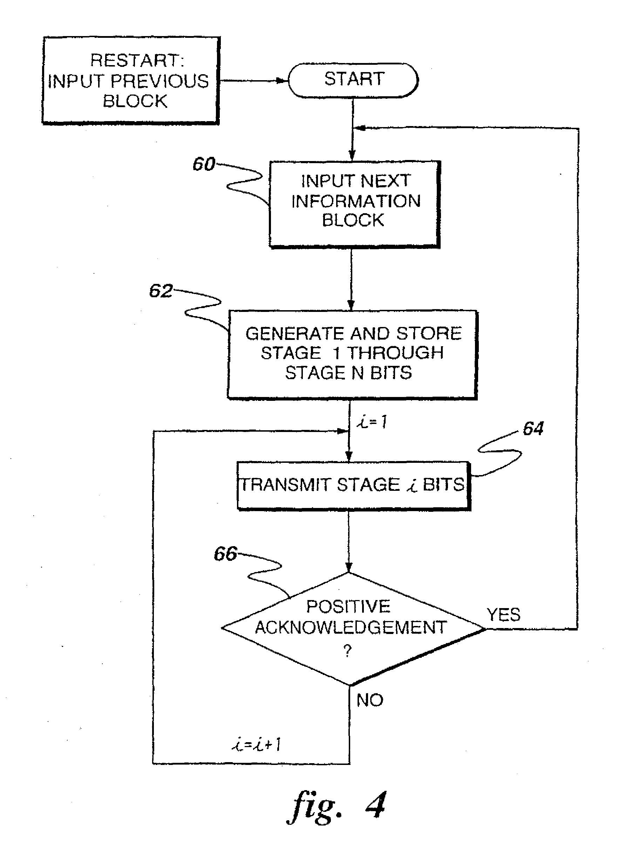

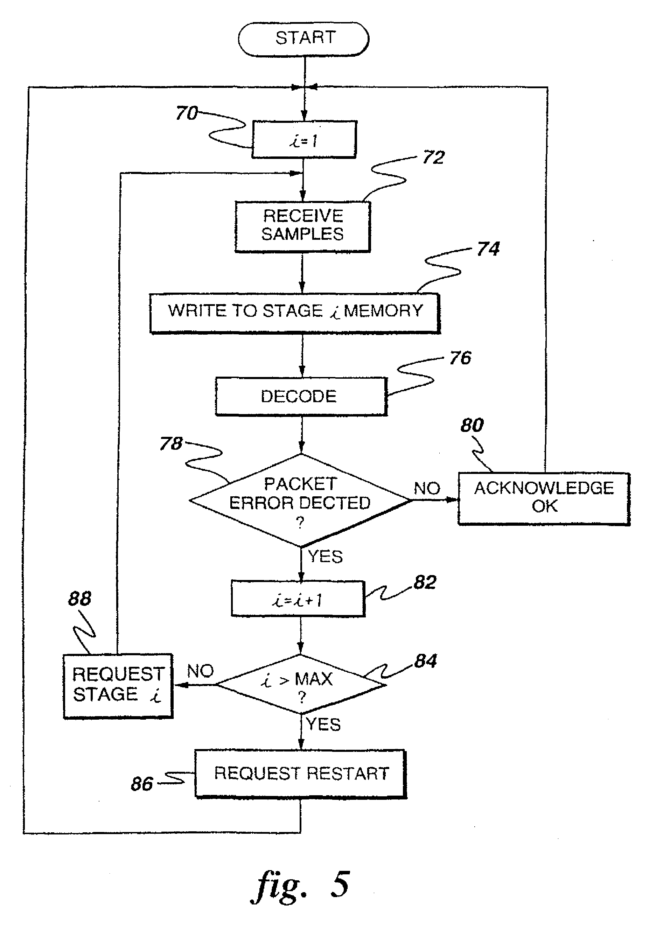

FIG. 4 is a flow chart illustrating turbo-coding at the transmitter end according to an embodiment of the present invention. In step 60, the first (or next) information block is provided to the transmitter. Step 62 involves generating and storing the stage one information through stage N bits. Stage i bits are transmitted in step 64. After the receiver determines whether there has been a packet transmission error, an indication of same is given to the transmitter in step 66. If positive acknowledgment (i.e., an indication of no error) is given, the process returns to step 60 wherein the next information block is provided to the transmitter. If an error is indicated (i.e., no positive acknowledgment), then the transmission stage i is incremented, and the process returns to step 64. The process continues by incrementing the information stage one until positive acknowledgment is made. FIG. 5 is a flow chart illustrating staged turbo-decoding, i.e., at the receiver end, according to an embodiment of the present invention. In step 70, the decoding stage i is set to one (1). In step 72, data samples are received, and in step 74, the received data samples are stored in memory. Turbo-decoding is performed in step 76, and a determination of a packet error is made in step 78. If not, then positive acknowledgment is made to the receiver in step 80. However, if a packet error is indicated in step 78, then the turbodecoding stage i is incremented in step 82. A test is made in step 84 to determine whether a predetermined limit on the number of turbodecoding stages (max) has been reached. If so, then a request to restart the turbo-decoding process is made in step 86. Otherwise, a request for stage i turbo-decoding is made in step 88, and the process returns to step 72.

In a turbo-coder, a method according to a first aspect comprises turbo-encoding source information to produce code bits, communicating code bits to a turbo-decoder and if an error indication is received from said turbo-decoder, communicating punctured code bits produced by puncturing the turbo encoded code bits to the turbo-decoder for use in turbo-decoding the non-punctured code bits.

According to a second aspect, in the method of the first aspect the turbo-encoding step comprises encoding the source information to produce concatenated at least first and second groups of code bits, the first and second groups of code bits are punctured to produce the punctured code bits, the punctured code bits are stored, the step of communicating code bits comprises communicating the first and second groups of non-punctured code bits communicated to said turbo-decoder and if an error indication is received from a turbo-decoder, the step of communicating comprises communicating at least a portion of the stored punctured code bits to the turbo-decoder for use in turbo-decoding the first and second groups af non-punctured code bits.

According to a third aspect, in the method of the first aspect the step of turbo-encoding comprises first and second encoding steps, the first encoding step applying a first convolutional code to the source information to provide the first group of code bits, the second encoding step applying a second convolutional code to the source information after interleaving the source information to provide the second group of code bits.

According to a method of a fourth aspect, in the method of the first aspect the turbo-encoding step comprises using systematic convolutional coding resulting in systematic code bits. According to a fifth aspect, in the method of the fourth aspect the step of puncturing comprises communicating a single copy of the systematic code bits and if an error indication is received from a turbo-decoder, the step of communicating comprises communicating at least a portion of the systematic code bits to the turbo-decoder for use in turbo-decoding.

According to a sixth aspect, in the method of the first aspect the step of puncturing comprises deleting code bits according to a predetermined puncturing pattern.

In a turbo-decoder that receives from a turbo-encoded code bits representing source information from a turbo-encoder, a method according to a seventh aspect comprises turbo-decoding samples corresponding to the received turbo-encoded code bits, determining whether or not there is an error in received turbo-encoded code bits, if an error is detected, requesting the turbo-encoder to communicate punctured code bits produced by puncturing the turbo encoded code bits to the turbo-decoder and turbo-decoding the samples corresponding to the turbo-encoded non-punctured code bits using samples of the punctured code bits communicated in response to the request generated in response to the detection of an error.

According to a method of an eighth aspect, in the method of the seventh aspect the source information is turbo-encoded by producing concatenated at least first and second groups of code bits, the step of turbo-decoding comprises turbo decoding samples of the first and second groups of code bits and if an error is detected, the step of turbo-decoding comprises turbo-decoding samples of the first and second groups of non-punctured code bits by combining the first and second groups of non-punctured code bits with the punctured code bits communicated in response to the request generated in response to the detection of an error.

According to a ninth aspect, in the method of the eighth aspect the first and second group of non-punctured code bits are generated in first and second encoding steps, the first encoding step applying a first convolutional code to the source information to provide the first group of code bits, the second encoding step applying a second convolutional code to the source information after interleaving the source information to provide the second group of code bits.

According to a tenth aspect, in the method of the seventh aspect the source information is turbo-encoded using systematic convolutional coding resulting in systematic code bits, the punctured code bits are generated by communicating a single copy of the systematic code bits, the step of requesting comprises requesting the turbo-encoder to communicate at least a portion of the systematic code bits to the turbo-decoder for use in turbo-decoding and the step of turbo-decoding comprises using samples of the systematic code bits communicated in response to the request generated in response to the detection of an error.

According to a method of an eleventh aspect, in the method of the seventh aspect the step of determining whether the code bits have been received in error comprises a cyclic redundancy check code.

According to a twelfth aspect, in the method of the eleventh aspect the cyclic redundancy check code comprises a 16-bit cyclic redundancy check code.

According to a thirteenth aspect, in the method of the seventh aspect the punctured code are formed by deleting code bits according to a predetermined puncturing pattern and the step of turbo-decoding comprises a depuncturing step for inserting neutral values for the punctured bits.

An encoder for information according to a fourteenth aspect comprises means for turbo-encoding information to produce code bits, means for communicating code bits to a turbo-decoder and means for responsive to an indication from the turbo-decoder that the turbo-coded code bits received contain an error communicating to the turbo-decoder punctured code bits produced by puncturing the turbo encoded code bits for use in turbo-decoding the non-punctured code bits.

According to a fifteenth aspect, in the turbo encoder of the fourteenth aspect the means for turbo-encoding uses systematic convolutional coding resulting in systematic code bits, the punctured code bits being generated by communicating a single copy of the systematic code bits and the means for responsive to an indication from the turbo-decoder that the turbo-coded code bits received contain an error, communicates at least a portion of the systematic bits to the turbo-decoder for use in turbo-decoding.

In a turbo-decoder that receives from turbo-encoder a turbo-encoded code bits representing information, a method according to a sixteenth aspect comprises means for turbo-decoding samples of the received turbo-encoded code bits, means for determining whether or not there is an error in received turbo-encoded code bits, means for generating an error indication to request the turbo-coder to communicate punctured code bits produced by puncturing the turbo encoded code bits to the turbo-decoder if an error is detected and means for turbo-decoding samples of the turbo-encoded non-punctured code bits using samples of the punctured code bits communicated to the turbo-decoder in response to the error indication.

According to a seventeenth aspect, in the turbo decoder of the sixteenth aspect the information is turbo-encoded using systematic convolutional codes resulting in systematic code bits, the punctured code bits being generated by communicating a single copy of the systematic code bits, the means for generating an error indication if an error is detected, requests the turbo-encoder to again communicate at least a portion of the systematic code bits to the turbo-decoder for use in turbo-decoding and the means for turbo-decoding turbo-decoding uses samples of the systematic code bits communicated in response to the request generated in response to the detection of an error.

A method for encoding information bits according to an eighteenth aspect comprises encoding information bits with a systematic code to generate systematic code bits and additional bits, puncturing the additional bits to generate punctured bits, communicating a data group comprising said systematic code bits and retaining said punctured bits.

According to a method of a nineteenth aspect, in the method of the eighteenth aspect the said systematic code is a recursive systematic code.

According to a method of a twentieth aspect, in the method of the eighteenth aspect the systematic code is a parallel concatenation of two recursive systematic codes.

According to a method of a twenty-first aspect, in the method of the eighteenth aspect the punctured bits are communicated to a decoder in response to a request from the decoder for additional information.

According to a method of a twenty-second aspect, in the method of the eighteenth aspect the punctured bits are recommunicated to a decoder in response to a request from the decoder for additional information.

In an encoder according to a twenty-third aspect the method of the eighteenth aspect, the method of the nineteenth aspect, the method of the twentieth aspect, the method of the twenty-first aspect or the method of the twenty-second aspect is performed.

A method for decoding a data group encoded by an encoder with a systematic code to generate systematic bits and additional bits according to a twenty-fourth aspect comprises receiving the data group comprising systematic bits and additional bits of an encoder with a systematic code, storing samples of the systematic bits and additional bits, decoding the stored samples, detecting the occurrence of an error in the decoding and requesting more information regarding the data group from the encoder if an error is detected.

According to a method of a twenty-fifth aspect, in the method of the twenty-fourth aspect the said systematic code is a recursive systematic code.

According to a method of a twenty sixth aspect, in the method of the twenty-fifth aspect the said systematic code is a parallel concatenation of two recursive systematic codes.

According to a method of a twenty-seventh aspect, in the method of the twenty-fourth aspect the step of decoding comprises an iterative algorithm.

According to a method of a twenty-eighth aspect, in the method of the twenty-fourth aspect the step of decoding comprises a turbo decoding algorithm.

According to a method of a twenty-ninth aspect, in the method of the twenty-fourth aspect the step of detecting an error comprises a cyclic redundancy check.

According to a method of a thirtieth aspect, in the method of the twenty-fourth aspect, when an error is detected, punctured code bits are requested from the encoder and the punctured code bits are used in for decoding.

In a coder according to a thirty-first aspect the method of the twenty-fourth aspect, the method of the twenty-fifth aspect, the method of the twenty-sixth aspect, the method of the twenty-seventh aspect, the method of the twenty-eighth aspect, the method of the twenty-ninth aspect or the method of the thirtieth aspect is performed.

## Claims

1. A method for turbo-coding information in stages in a communication system, comprising
turbo-encoding source information;
generating a punctured set of code bits (P1, P2) and generating non-punctured code bits (C1, C2);
wherein the punctured code-bits (P1, P2) are generated such that some or all of the punctured code bits (P1, P2) can be forwarded on a request of the turbo-decoder (40) in a corresponding stage;
transmitting non-punctured code bits (C1, C2) of one stage to a turbo-decoder (40); and
if an error indication is received from the turbo-decoder (40) incrementing the stage and transmitting the punctured code-bits (P1, P2) of the corresponding stage to the turbo-decoder (40);
wherein the stage is incremented until a restart is requested if a predetermined limit on the number of stages has been reached in order to allow for two or more stages of decoding, depending upon an application.

2. The method of claim 1, further comprising:
restarting turbo coding on a request.

3. The method of claim 1 or2, wherein:
if an error indication is received from said turbo-decoder (40), transmitting the punctured code bits (P1, P2) and/or a second set of systematic bits to the turbo-decoder (40) to be used in a corresponding stage.

4. The method of one of claims 1 to 3, wherein:
the size of a set of punctured code bits (P1, P2) is determined by the bandwidth, power and/or the retransmission frequency of the system.

5. The method of one of claims 1 to 4, wherein:
a new stage of information allows for decoding with a more complete information.

6. A method for staged turbo-decoding for a communication system, comprising:
turbo-decoding in a first stage turbo-encoded code bits (C1, C2) received from a turbo-encoder (12, 24, 26);
determining whether or not there is an error;
if an error is detected requesting by an error indication the turbo-encoder to transmit at least a portion of punctured code bits (P1, P2) for an incremented stage; and
turbo-decoding the turbo-encoded code bits using the punctured code bits (P1, P2);
wherein the request for an incremented stage is made until a predetermined limit on the number of stages has been reached in order to allow for two or more stages of decoding, depending upon an application.

7. The method of claim 6, wherein:
turbo-decoding comprises combining the punctured code bits (P1, P2) with the original received data samples bits.

8. The method of claim 6 or 7, wherein:
the step of determining whether or not there is an error uses a cyclic redundancy check code.

9. The method of one of claims 6 to 8, wherein:
wherein a new stage of information allows for decoding with a more complete information.

10. An apparatus for turbo-coding information in stages for a communication system, comprising
means for turbo-encoding source information;
means for generating a punctured set of code bits (P1, P2) and for generating non-punctured code bits (C1, C2);
wherein the punctured code-bits (P1, P2) are generated such that some or all of the punctured code bits (P1, P2) can be forwarded on a request of the turbo decoder (40) in a corresponding stage;
means for transmitting non-punctured code bits (C1, C2) of one stage to a turbo-decoder (40); and
means for incrementing the stage and for transmitting the punctured code bits (P1, P2) of the corresponding stage to the turbo-decoder (40), if an error indication is received from the turbo-decoder (40);
wherein the stage is incremented until a restart is requested if a predetermined limit on the number of stages has been reached in order to allow for two or more stages of decoding, depending upon an application.

11. The apparatus of claim 10, wherein the apparatus is adapted for:
restarting turbo coding on a request.

12. The apparatus of claim 10 or 11, wherein:
transmitting punctured code bits comprises transmitting punctured code bits (P1, P2) and/or a second set of the systematic bits to the turbo-decoder (40) to be used in a corresponding stage.

13. An apparatus for staged turbo-decoding for a communication system, comprising:
means for turbo-decoding in a first stage turbo-encoded code bits (C1, C2) received from a turbo-encoder (12, 24, 26);
means for determining whether or not there is an error; and
means for requesting by an error indication the turbo-encoder to transmit at least a portion of punctured code bits (P1, P2) for an incremented stage if an error is detected ; and
for turbo-decoding the turbo-encoded code bits using the punctured code bits (P1, P2);
wherein the apparatus for decoding is adapted for making the request for an incremented stage until a predetermined limit on the number of stages has been reached in order to allow for two or more stages of decoding, depending upon an application.

14. The method of claim 13, wherein:
turbo-decoding comprises combining the punctured code bits (P1, P2) with the original received data samples bits.

15. The method of claim 13 or 14 wherein:
the step of determining whether or not there is an error uses a cyclic redundancy check code.
